# EUROPEAN PATENT APPLICATION

(11) **EP 1 076 479 A1**
(43) Date of publication of application: **14.02.2001**
(21) Application number: 00305724.7
(22) Date of filing: 06.07.2000
(51) Int. Cl.: H05K 3/00, H05K 5/00

(54) **Integrated sensor/controller assembly and method of manufacturing same**

(30) Priority: 23.07.1999 US 359718
(71) Applicant: Ford Motor Company, Dearborn, MI 48126 (US)
(72) Inventor: Barua, Debojit, Troy, Michigan 48098 (US); Gietzen, Diane M., Warren, Michigan 48093 (US); Mondro, James J., Dearborn, Michigan 48124 (US); Supina, Joseph Gerald, Belleville, Michigan 48111 (US); McMillan, Richard Keith, Dearborn, Michigan 48124 (US)
(74) Representative: Messulam, Alec Moses

(57) **Abstract**

An electronic sensor assembly includes a circuit board (36) having a first generally planar portion (40) upon which at least one sensor component (48) is mounted, and a second generally planar portion (38) upon which at least one signal-processing component (50) is mounted. The first and second portions (40,38) of the circuit board (36) are non-coplanar and, preferably, are perpendicular to one another to thereby facilitate assembly packaging within a given housing, and to improve relative positioning of the sensor components (48) within such a housing with increased reliability and at lower cost. The mounting of all assembly components on a common circuit board advantageously improves assembly reliability and service life.

## Description

The invention relates to electronic assemblies which include an electronic component mounted on each of two electrically interconnected, non-coplanar circuit boards, wherein the electronic component on one circuit board is disposed a predetermined distance from a reference plane falling within the other circuit board.

The prior art teaches electronic assemblies and, particularly, electronic sensor assemblies or subsystems, wherein an electromechanical or electronic sensor mounted on a first relatively rigid circuit board is placed in electrical communication with other "local" electronic components, such as a microprocessor and an external connector, mounted on an adjacent, relatively rigid circuit board that is otherwise noncoplanar with the first circuit board. In this manner, for example, a plurality of electronic sensor assemblies are provided which locally process, normalise or otherwise qualify the raw output of the electromechanical or electronic sensor to thereby provide information, often in digital form, which may be sent over a shared data bus via the external connector for use by a remote processor. Typical electronic sensor assemblies thereby provide locally processed information regarding a wide variety of physical parameters, conditions or characteristics, such as temperature, static pressure information, electromagnetic field information, and so on.

In accordance with one prior art method, the two relatively rigid circuit boards, upon which the sensor and processing components are respectively mounted, are typically interconnected using appropriate cable interconnects, thereby requiring both the cost and increased assembly complexity of defining electrical connectors on each circuit board, and the requisite customised cabling. A further drawback of this prior art approach is the lowered overall reliability of the resulting electronic sensor assembly, due to the additional failure modes introduced by the plural electrical interconnects, as well as by the cabling itself.

Under a second known approach, the prior art teaches the use of electrical interconnects which are capable of providing both electrically and mechanically robust interconnections between the respective circuit boards. By way of example only, such an electronic sensor assembly is disclosed in the context of a liquid level sensor device in U.S. Patent No. 5,627,523. While the latter approach advantageously eliminates the need for customised cabling, the second approach nonetheless implicates greater design and manufacturing costs through use of the various multifunction interconnects, including those incident to any requirement that the sensor components of such multiple interconnected circuit boards be precisely positioned relative to an external housing.

Further, the second approach continues to disadvantageously present the additional failure modes of the plural electrical and mechanical interconnects. Additionally, use of the second approach tends to be constrained by the packaging requirements of the various electronic sensor assemblies with which it might otherwise be used. For example, in U.S. Patent No. 5,627,523, it will be seen that the amount of space on each interconnected circuit board which may be employed for sensing and/or processing components is relatively small, thereby limiting its applicability.

What is needed, then, is an electronic assembly, such an electronic sensor assembly, and a method of making same, wherein the controller and sensor are respectively mounted on discrete, preferably non-coplanar portions of a common relatively rigid circuit board.

Under the invention, a method for making an electronic assembly includes defining, on a circuit board having a substantially rigid substrate material capable of being shaped when heated to a first temperature above the operating temperature, a first generally planar portion, a second generally planar portion, and a bending region separating the first portion from the second portion, wherein the bending region includes at least one electrically conductive trace extending between the first portion and the second portion. The method includes mounting, on the first portion of the circuit board, one or more first "externally interacting" electronic components (hereinafter "interacting components") from the group consisting of a sensor component, an indicator component, an actuator component, and an input device, by which the assembly interacts with its surroundings, such that each mounted first electronic component is in electrical communication with the trace(s) bridging the two portions of the circuit board. Thus, in an exemplary embodiment, at least one sensor component operative to generate an output signal is mounted on the first portion of the circuit board, in electrical communication with the traces formed in the circuit board's bending region.

The method further includes mounting, on the second portion of the circuit board, a second, signal-processing electronic component, such that each mounted signal-processing component is likewise in electrical communication with one or more traces bridging the two portions of the circuit board. Thus, in the exemplary embodiment, a signal-processing component mounted on the second portion of the circuit board is placed in electrical communication with each sensor component mounted on the circuit board's first portion.

The method further includes, after respectively mounting the interacting and signal-processing electronic components to the first and second portions of the circuit board, heating the circuit board to the substrate's glass transition temperature; and bending the substrate in the bending region to achieve a predetermined shape characterised in that the first portion is no longer coplanar with the second portion. By way of example only, in an exemplary embodiment, the substrate is bent by clamping the circuit board, providing a moving roller and a stationary roller on opposite sides of the circuit board, and moving the moving roller so that the circuit board bends around the stationary roller. A preferred method of practising the invention also includes reducing the thickness of the circuit board in the bending region and, more specifically, removing material from the bending region on the "compression" side, e.g., on the internal side of the bend, to facilitate bending while further ensuring that the circuit board, once cooled, rigidly maintains its "bent" shape.

The "bent" circuit board is preferably inserted within an assembly housing while the bending region remains heated to the laminate's glass transition temperature. In this manner, the circuit board readily accommodates any accumulated tolerances generated during manufacture of the circuit board and/or the housing, thereby substantially reducing assembly-induced stresses in the circuit board.

Moreover, the insertion of the still-heated circuit board advantageously permits the press-fitting of a plurality of apertures, formed in the second portion of the circuit board, about a like number of electrically conductive pins projecting into the assembly's housing. In this manner, an improved electrical interconnection is achieved between the second portion of the circuit board and an external connector on the housing while further accommodating slight misalignment between the conductive pins and the circuit board apertures.

Under the invention, an electronic assembly includes a substantially rigid circuit board having a substrate formed of a material capable of being shaped when heated to a first temperature above the operating temperature, wherein the circuit board has a first generally planar portion, and a second generally planar portion separated from the first portion by a bent region, the bent region including at least one and, preferably, a plurality of electrically conductive traces extending between the first portion and the second portion of the circuit board. While the invention contemplates any noncoplanar orientation of the first portion relative to the reference plane within the second portion, in an exemplary embodiment, the circuit board's first portion extends in a direction generally normal to the reference plane within the second portion.

The electronic assembly also includes at least one externally interacting electronic component from the group consisting of a sensor component (e.g., a resistor bridge), an indicator component (e.g., a light-emitting diode), an actuator component (e.g., a motor), and an input device (e.g., a switch), mounted on the first portion of the circuit board in electrical communication with the trace(s) extending between the first and second portions of the circuit board. Each interacting component mounted on the first portion of the circuit board is disposed a respective distance from a reference plane defined within the second portion of the circuit board. Thus, in the exemplary embodiment, a pair of sensor components, each mounted on the circuit board's first portion, respectively operate to generate an output signal representing a local physical parameter, condition or characteristic, with each sensor component being precisely positioned a respective distance from the reference plane within the second portion of the circuit board.

The electronic assembly further includes a second, signal-processing electronic component mounted on the second portion of the circuit board so as to be in electrical communication with the trace(s) extending between the circuit board's first and second portions. In this way, the signal-processing component receives the signal generated by, or relays a signal to, each interacting component mounted on first portion of the circuit board.

And, in the exemplary embodiment, the electronic assembly includes an upper housing adapted to receive the second portion of the circuit board, and a lower housing adapted to receive the first portion of the circuit board. The upper housing includes an electrically conductive pin projecting into the upper housing and received, in interference fit, within an aperture defined in the second portion of the circuit board. The aperture is lined with an electrically conductive material that is in electrical communication with the signal-processing component, whereby signals are communicated from the signal-processing component to the housing's pin. The pin on the upper housing preferably forms a part of an external connector defined on the upper housing. Preferably, a potting material in the upper housing overlies the second portion of the circuit board to thereby environmentally seal the circuit board within the housing without requiring the use of a cap or similar structure.

As a feature of the invention, the assembly's interacting components and signal-processing components advantageously share a common substrate, thereby eliminating failure modes characteristic of prior art assemblies. Further, the use of a single substrate, precisely bent along the bending region, provides an assembly featuring a circuit board whose second portion is readily and conveniently mounted in a housing, with the interacting components on the circuit board's first portion being precisely positioned relative to the reference plane within the second portion and, hence, relative to the housing.

The present invention will now be described further, by way of example, with reference to the accompanying drawings, in which:
Figure 1 is a side elevational view, partially broken away, of a fuel accumulator incorporating an exemplary sensor/controller assembly in accordance with the invention;
Figure 2 is an exploded view in perspective of the sensor/controller assembly of Figure 1;
Figure 3 is a top view of the sensor/ controller assembly of Figure 1, with the potting material removed for clarity of illustration; and
Figure 4 is a cross-sectional view of the sensor/controller assembly taken along line 4-4 of Figure 3 (illustrating the potting material with which the second portion of the assembly's circuit board is sealingly secured within the assembly's upper housing).

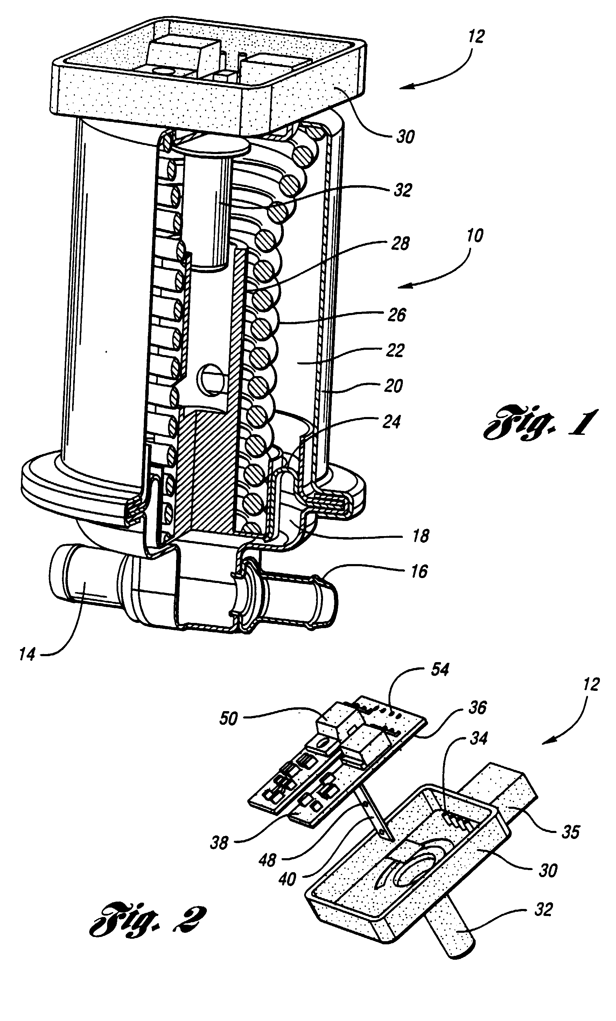

Referring to Figure 1, a fuel accumulator 10 incorporating an exemplary integrated sensor/ controller assembly 12 in accordance with the invention includes a fuel inlet 14 and a fuel outlet 16 in fluid communication with a lower chamber 18 defined within the fuel accumulator's generally elongated housing 20. The housing's lower chamber 18 is separated from an upper chamber 22 defined within the housing 20 by a flexible diaphragm 24. The diaphragm 24, which is mechanically urged towards the fuel inlet and outlet 14,16 by a coil spring 26, carries an annular magnet assembly 28.

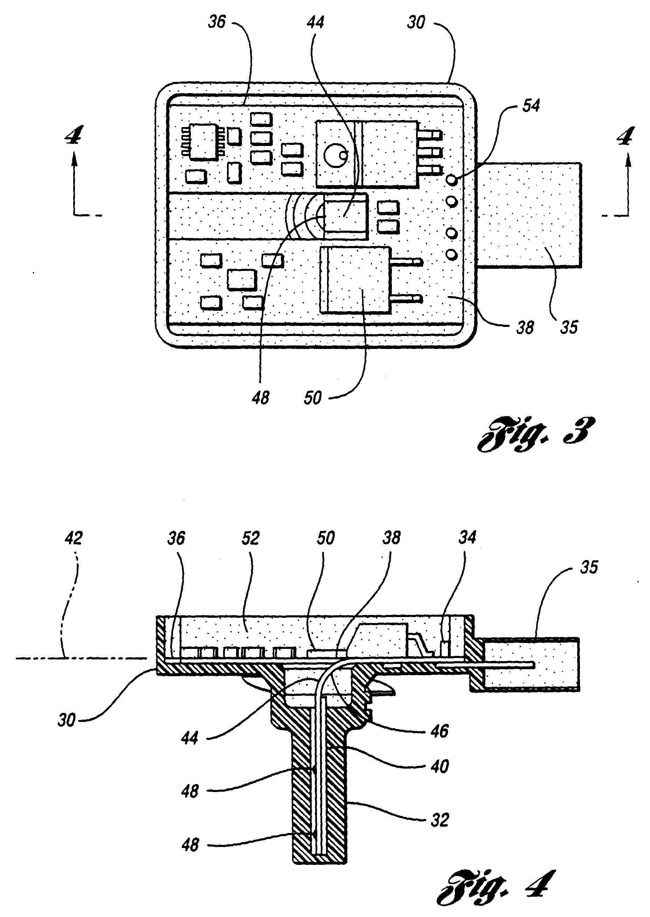

As best seen in Figures 2-4, the sensor/ controller assembly 12 for the fuel accumulator 10 includes a relatively enlarged upper housing 30 mounted atop the fuel accumulator housing 20, and a relatively narrow lower housing 32 of generally tubular configuration extending down from the upper housing 30 so as to extend into the upper chamber 22 defined within the fuel accumulator housing 20. More specifically, the lower housing 32 extends into the fuel accumulator's upper chamber 22 in such a manner as to be increasingly encompassed by the magnet assembly 28 as the fuel accumulator 10 is filled with fuel.

By way of example only, in a preferred embodiment, the sensor/controller assembly's upper housing 30 and tubular lower housing 32 are integrally formed of a plastic material, as through use of an injection moulding process using a suitable fuel resistant plastic, e.g., acetyl or polyphenylene sulphide (PPS). As discussed more fully below, in accordance with another feature of the invention, a plurality of electrically conductive pins 34 project into the upper housing 30 to form the connection between an external connector 35 and a substantially rigid printed circuit board 36 to be mounted or otherwise suitably supported within the upper housing 30.

While the invention contemplates use of circuit boards 36 of any suitable configuration, in the exemplary sensor/controller assembly 12, the circuit board 36 is a multilayer circuit board including several alternating layers of electrically conductive copper traces and an electrically insulating material such as FR4 (a flame retardant epoxy-glass fabric composite material). The laminate material, which is substantially rigid at the assembly's maximum operating temperature, becomes flexible upon the application of relatively high temperatures, i.e., thermoplastic or thermoset materials are used and the glass transition temperature T_{g} is exceeded, resulting in elastomeric mechanical behaviour.

The circuit board 36 is generally characterised by an upper portion 38 which fully resides within the upper housing 30; and a lower portion 40, integrally formed with the upper portion 38, which extends in a direction generally normal to a reference plane 42 defined within the upper portion 38, such that the lower portion 40 extends from the upper housing 30 into the tubular lower housing 32. The circuit board 36 also includes a bending region 44 disposed between the upper portion 38 and the lower portion 40. By way of example only, in the exemplary sensor/controller assembly 12, the bending region 44 includes a groove (not shown) formed in one surface 46 of the circuit board 36.

As best seen in Figures 2 and 4, a pair of sensor components, indicated generally at 48, are mounted on the lower portion 40 of the circuit board 36 such that the sensor components 48 are located at a plurality of relative distances from the reference plane 42 defined within the circuit board's upper portion 38. In this manner, the sensor components 48 are respectively positioned at different longitudinal positions within the tubular lower housing 32.

By way of example only, in the fuel accumulator 10 illustrated in the Drawings, each sensor component 48 of the exemplary assembly 12 includes a suitable bridge circuit having a pair of giant magnetoresistive elements. The giant magnetoresistive elements are multilayer structures of alternating Copper and Cobalt layers of definite thickness, e.g., between about (10 to 20 Angstroms), the electrical resistance of which is reduced dramatically (up to perhaps about 50%) when a magnetic field is presented in the plane of the structure. Each sensor component 48 is thus operative to generate a signal in response to the relative longitudinal position of the magnet assembly 28 as it is displaced by the diaphragm 24.

Each sensor component 48 is mounted on the lower portion 40 of the circuit board 36 so as to be electrically interconnected, via the circuit board's electrically conductive traces, with at least one signal-processing component 50, i.e., a dual comparator, mounted on the upper portion of the circuit board. In the preferred embodiment, the electrical interconnection between the bridge circuits and the traces is achieved using standard aluminium wire bonding; however, it will be appreciated that other mounting/interconnection designs can be used, including the use of flipchips having solder bumps or gold stud bumps on an underside of the chip.

A potting material 52 overlying the upper portion 38 of the circuit board 36 within the upper housing 30 protects the assembly components 36,48,50 from exposure to fuel and fuel vapour while eliminating the need for a separate cover lid and lid attachment. While the invention contemplates use of any suitable potting material 52, the exemplary assembly 12 employs a relatively low-modulus epoxy, e.g., Thermoset ES-63.

In accordance with a feature of the invention, the upper portion 40 of the circuit board 36 includes a plurality of conductor-lined apertures 54, in electrical communication with the signal-processing components 50, which receive, in interference fit, the conductive pins 34 projecting from the upper housing 30. In this manner, the signal-processing components 50 on the upper portion 38 of the circuit board 36 are advantageously electrically connected with the assembly's external connector 35 without resort to the heavy wire bonds typically found in prior art assemblies, thereby further reducing manufacturing and assembly costs associated with the exemplary assembly 12.

In operation, when the fuel accumulator 10 is empty, the magnet assembly 28 saturates the resistor pair of the lower sensor component 48 (assumes a relatively low-resistance state), while the resistor pair of the upper sensor component 48 -- which is essentially outside of the magnetic field generated by the magnet assembly 28 --remains unsaturated (assumes a relatively high-resistance state). When the accumulator is filled, the resistor pair of the upper sensor component 48 is saturated (assumes a low-resistance state) by the field generated by the magnet assembly 28 while the resistor pair of the lower sensor component 48 becomes unsaturated (assumes a relatively high-resistance state). The signal generated by each sensor component 48, i.e., its bridge output, is fed into the comparator 50 mounted on the upper portion 38 of the circuit board 36. The comparator 50 determines the relative fill of the accumulator 10 based on the bridge outputs and, in response, operates a fuel pump (not shown) through a power driver (also not shown).

In accordance with another feature of the invention, a preferred method of practising the invention includes defining, on a circuit board, a first and second generally planar portion separated by a bending region 44. While the bending region 44 may be defined in any suitable manner, in a preferred method for making the exemplary sensor/controller assembly 12 illustrated in the Drawings, the bending region 44 is defined by machining a groove (not shown) in one surface 46 of the circuit board 36, as with a carbide end-mill, fly cutter, or similar tool, prior to populating the circuit board 36 with any electronic components 48,50. In this regard, it is noted that the electrically conductive traces are preferably located within the circuit board 36 such that the traces remain undisturbed during any such machining process. A common circuit routing program, for example, may be used to route the conductive traces preferentially toward the other side of the circuit board 36.

More specifically, in the preferred method, the groove is cut deep enough into the one surface 46 of the circuit board 36 to allow bending under elevated temperatures as further described below while keeping circuit board 36 rigid at ambient temperatures during population with electrical components, testing and shipment. The thickness in the bending region 44 after cutting the groove is typically below 25 mils. The width of the bending region 44 will vary depending on the thickness of the remaining material in bend region, the number of layers of electrically conductive traces, and the degree to which the circuit board 36 will subsequently be bent. For example, if a circuit board 36 having a nominal thickness of 0.062 in. is cut to a depth of 0.040 in., a bending region 44 of at least 0.5 in. provides sufficient width.

A plurality of sensor components 48 and signal-processing components 50 are provided for mounting on the first portion and second portion of the circuit board 36, respectively. For example, while the magnetoresistive bridge circuits of the exemplary assembly 12 may be provided in any suitable manner, in a preferred method, multilayers of copper and cobalt are sputtered on to a silicon substrate, followed by standard photolithography and etching techniques to define the serpentine resistor patterns. Aluminium contact pads are formed by standard methods of masking, photolithography, vapour deposition or sputtering, and liftoff. A passivation layer of silicon nitride or silicon oxide is preferably applied over the magnetoresistive bridge circuit to improve bridge performance and service life.

The sensor components (e.g., the magnetoresistive bridge circuits 48) and the signal-processing components 50 are then respectively mounted to the first and second portions of the circuit board 46. By way of example only, the magnetoresistive bridge circuits of the exemplary assembly's sensor components 48 are attached to the first portion 42 of the circuit board 36 using an epoxy, and wire bonded to the bond pads on the circuit board 36 to achieve electrical interconnection between the sensor component 48 and the circuit board's traces. In the event that flipchip sensor components 48 are to be used, a preferred method includes under-filling each flipchip simultaneously with die bonding using Hysol LF 69506-2, as described in U.S. Patent No. 5,579,573. Similarly, the signal-processing components 50 are mounted to the second portion 40 of the circuit board 36 in a suitable manner, for example, as through solder printing and reflowing, so as to likewise be electrically interconnected with the traces of the circuit board 36.

The circuit board 36 is then heated to the laminate's glass transition temperature T_{g} and processed through a bending apparatus (not shown), wherein the first and second portions of the circuit board are respectively clamped, and the grooved side 46 of the bending region 44 is bent around a stationary roller with the help of a moving roller engaging the circuit board's other side.

After the circuit board 36 has been bent in the bending region 44 to achieve a suitable predetermined shape, e.g., to position the first portion of the circuit board generally normal to the second portion of the board as seen in Figures 2 and 4, and with the circuit board 36 still heated to a temperature greater than the maximum operating temperature of the assembly 12, the circuit board 36 is immediately inserted into the upper housing 30 such that the first portion of the circuit board 36 projects a predetermined distance into the lower housing 32. The insertion of the heated circuit board 36 ensures that the circuit board 36 readily accommodates any accumulated tolerances generated during manufacture of the circuit board 36 and/or the upper and lower housings 30,32, thereby substantially reducing assembly-induced stresses in the circuit board 36.

In the preferred method, inserting also includes achieving an interference fit between the conductor-lined apertures 54 formed in the second portion 40 of the circuit board 36 about the electrically conductive pins 34 projecting into the assembly's upper housing 30. In this manner, an improved electrical interconnection is achieved between the second portion 40 of the circuit board 36 and the assembly's external connector 35 while further accommodating slight misalignment between the conductive pins 34 and the circuit board apertures 54.

The preferred method further includes potting the inserted circuit board 36 with a low-modulus epoxy, e.g., Thermoset ES-63, to complete the packaging and to protect the assembly's components 36,48,50 from exposure to the service environment, i.e, fuel and fuel vapour. As a further benefit of the invention, the use of suitable assembly-sealing potting material advantageously eliminates the need for providing and otherwise assembling a separate cover lid and lid attachment, along with the need for a separate seal-testing step.

While the best mode for carrying out the invention has been described in detail, those familiar with the art to which this invention relates will recognise various alternative designs and embodiments for practising the invention within the scope of the appended claims. For example, while the exemplary integrated sensor/controller assembly 12 includes a circuit board 36 having only one "bent" lower portion 40 which extends in a direction generally normal to the reference plane 42 defined within the upper portion 38, the invention contemplates the use of a plurality of such bent lower portions 40, each of which may define either a substantially similar or substantially different angle with respect to the reference plane 42 in the upper portion 38. In this manner, a plurality of interacting components may be respectively positioned within a given housing while otherwise maintaining the ease at which the circuit board 36 is mounted, via the upper portion 38 thereof, within the housing. Similarly, the invention contemplates multiple "bends" in a given lower portion 40 to thereby obtain U-shaped, zig-zag, or other "finger" shapes having multiple "interacting" components or regions thereon.

## Claims

1. A method for making an electronic assembly for use at an operating temperature, the method comprising:
defining, on a circuit board (36) having a substantially rigid substrate material capable of being shaped when heated to a first temperature above the operating temperature, a first generally planar portion (40), a second generally planar portion (38), and a bending region (44) separating the first portion from the second portion, wherein the bending region (44) includes at least one electrically conductive trace extending between the first portion and the second portion;
mounting at least one first component (48) on the first portion (40) in electrical communication with the at least one trace, each first component being one of the group consisting of a sensor component, an indicator component, an actuator component, and an input device;
mounting a second electronic component (50) on the second portion (38) in electrical communication with the at least one trace, the second electronic component being a signal -processing component;
after mounting the first and second components (48,50), heating the circuit board (36) to the first temperature; and
bending the circuit board, in the bending region (44), into a predetermined shape characterised in that the first portion (40) is not coplanar with a reference plane (42) defined within the second portion (38), whereupon each first component (48) is disposed a respective unique distance from the reference plane (42).

2. A method as claimed in claim 1, wherein bending includes:
clamping the circuit board;
providing a moving roller and a stationary roller on opposite sides of the circuit board; and
moving the moving roller so that the circuit board bends around the stationary roller into the predetermined shape.

3. An electronic assembly comprising:
a substantially rigid circuit board having a substrate formed of a material capable of being shaped when heated to a first temperature above the operating temperature, wherein the circuit board has a first generally planar portion and a second generally planar portion separated from the first portion by a bent region, the first portion being noncoplanar with respect to a reference plane defined within the second portion, and wherein at least one electrically conductive trace extends between the first portion and the second portion;
at least one externally interacting electronic component mounted on the first portion of the circuit board in electrical communication with at least one trace, each interacting component being one of the group consisting of a sensor component, an indicator component, an actuator component, and an input device, and each interacting component being disposed a respective unique distance from the reference plane; and
a signal-processing electronic component mounted on the second portion in electrical communication with the at least one trace.

4. An assembly as claimed in claim 3, wherein the first portion extends in a direction generally normal to the reference plane.

5. An assembly as claimed in claim 3, further including:
an upper housing adapted to receive the second portion and a lower housing adapted to receive the first portion, the upper housing including an electrically conductive pin projecting into the upper housing; and
wherein the second portion includes at least one aperture defined therein, the aperture being lined with an electrically conductive material in communication with the signal-processing component, and wherein the lined aperture receives the pin in an interference fit.

6. An assembly as claimed in claim 5, further including a potting material in the upper housing overlying the second portion.

7. An electronic sensor assembly comprising:
a substantially rigid circuit board having a substrate formed of a material capable of being shaped when heated to a first temperature above the operating temperature, wherein the circuit board has a first generally planar portion and a second generally planar portion separated from the first portion by a bent region, the first portion being noncoplanar with respect to a reference plane defined within the second portion, and wherein a plurality of electrically conductive traces extend between the first portion and the second portion;
at least two sensor components mounted on the first portion in electrical communication with the traces, each sensor component being operative to generate an output signal, and each sensor component being disposed a respective unique distance from the reference plane; and
a signal-processing component mounted on the second portion in electrical communication with the at least one trace, whereby the signal-processing component receives the output signal generated by each sensor component.

8. An assembly as claimed in claim 7, wherein the first portion extends in a direction generally normal to the reference plane.

9. An assembly as claimed in claim 8, further including:
an upper housing adapted to receive the second portion and a lower housing adapted to receive the first portion, the upper housing including an electrically conductive pin projecting into the upper housing; and
wherein the second portion includes at least one aperture defined therein, the aperture being lined with an electrically conductive material in communication at least one of the sensor components and the signal-processing component, and the lined aperture receiving the pin in an interference fit.

10. An assembly as claimed in claim 9, further including a potting material in the upper housing overlying the second portion.
